# EUROPEAN PATENT APPLICATION

(11) **EP 1 775 259 A1**
(43) Date of publication of application: **18.04.2007**
(21) Application number: 05425719.1
(22) Date of filing: 14.10.2005
(51) Int. Cl.: B81B 7/02

(54) **Wafer level package for sensor devices**

(71) Applicant: STMicroelectronics S.r.l., 20041 Agrate Brianza (Milano) (IT)
(72) Inventor: Combi, Chantal, 23848 Oggiono (IT); Vigna, Benedetto, 85100 Potenza (IT); Ziglioli, Federico Giovanni, 20060 Gessate (IT); Baldo, Lorenzo, 20010 Bareggio (IT)
(74) Representative: Cerbaro, Elena

(57) **Abstract**

In a substrate-level assembly (22), a device substrate (20) of semiconductor material has a top face (20a) and houses a first integrated device (1), provided with a buried cavity (3), formed within the device substrate (20), and with a membrane (4), suspended over the buried cavity (3) in the proximity of the top face (20a). A capping substrate (21) is mechanically coupled to the device substrate (20) above the top face (20a) so as to cover the first integrated device (1), in such a manner that a first empty space (25) is provided above the membrane (4). Electrical-contact elements (28a, 28b) electrically connect the integrated device (1) with the outside of the substrate-level assembly (22). The device substrate (20) integrates at least a further integrated device (1', 10) provided with a respective membrane (4'); and a further empty space (25'), fluidically isolated from the first empty space (25), is provided over the respective membrane (4') of the further integrated device (1', 10).

## Description

The present invention relates to a substrate-level assembly (usually known as "wafer-level package") for integrated devices, in particular including sensor devices, and to a corresponding manufacturing process.

Semiconductor sensors are known (for example, pressure sensors, inertial sensors, gas sensors, or microphones) made with microfabrication techniques, whose operation is based upon detection of a deformation of a membrane, which is suspended over a cavity.

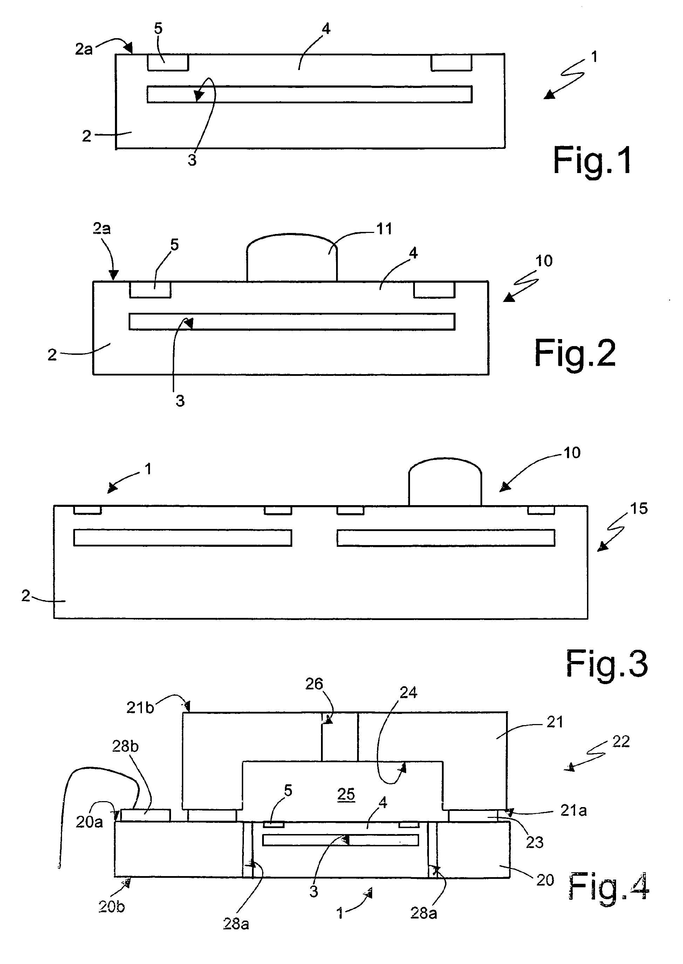

In particular, EP 1 577 656, filed in the name of the present applicant, discloses a pressure sensor and a manufacturing process thereof. In detail (Figure 1), the pressure sensor, designated by 1, is integrated in a substrate 2 made of semiconductor material, in particular monocrystalline silicon, having a top surface 2a. A buried cavity 3 is formed within the substrate 2, and is separated from the top surface 2a by a flexible and deformable membrane 4 suspended over the buried cavity 3. The buried cavity 3 is isolated and entirely contained within the substrate 2. Transduction elements 5, namely, piezoresistors formed by diffusion or implantation of dopant atoms, are arranged within the membrane 4, detect deformations of the membrane 4 (due to an applied pressure), and generate corresponding electrical signals as a function of the pressure to be detected. In brief, the manufacturing process of the pressure sensor 1 envisages: forming, within the substrate 2, a plurality of deep trenches, separated from one another by separation walls made of semiconductor material; then carrying out an epitaxial growth in a deoxidizing environment so as to form an epitaxial layer, which closes the deep trenches at the top; and, finally, carrying out a thermal annealing step so as to form the buried cavity 3. A thin silicon layer remains above the buried cavity 3, and is constituted partly by epitaxially grown silicon atoms and partly by migrated silicon atoms; this silicon layer forms the membrane 4.

The patent application EP 05425028.7, filed in the name of the present applicant on January 25, 2005, describes a piezoresistive accelerometer and a corresponding manufacturing process. In detail (Figure 2), the piezoresistive accelerometer, designated by 10, has a structure substantially similar to that of the pressure sensor 1 described above, so that parts that are similar are designated by the same reference numbers, and moreover has an inertial mass 11, formed on the membrane 4, in particular approximately at the geometrical centre of the membrane 4. The inertial mass 11 is constituted by welding paste, for example of silver, tin, copper, lead, gold, or other high-density metals, preferably having a density higher than 7000 kg/m³. For example, the inertial mass 11 comprises a cylindrical base portion and a hemispherical top portion, and has a radius of between 100 µm and 200 µm and a thickness of between 50 µm and 350 µm (given a side of the membrane 4 of approximately 500 µm, the ratio between the radius of the inertial mass 11 and the side of the membrane 4 is between 20% and 40%).

The inertial mass 11 is deposited through a metal mesh, made, for example, of nickel or steel, having suitable openings in positions corresponding to the areas where the welding paste is to be deposited. Furthermore, the deposition is accompanied by a temperature increase step, during which the inertial mass 11 adheres to the top surface of the membrane 4, assuming, after cooling, the described shape.

The centre of gravity G of the inertial mass 11 is placed outside of the membrane 4, so that, in use, an acceleration acting on the accelerometer 10 determines a momentum on the inertial mass 11, which causes inclination thereof in a corresponding direction. The displacement of the inertial mass 11 causes a deformation of the membrane 4 and a variation in the resistivity of the piezoresistive elements 5, whence an appropriate detection circuit determines the amount of the acceleration acting on the accelerometer 10.

The aforesaid patent application No. EP 05425028.7 further discloses (Figure 3) integration of the pressure sensor 1 and of the accelerometer 10 described above in separate and distinct surface portions of a same substrate 2 of semiconductor material, in particular to obtain a pressure monitoring system 15, for example, a so-called tyre-pressure monitoring system (TPMS) for monitoring the inflating pressure of a tyre for a vehicle. In use, the pressure monitoring system 15 is installed on the inside surface of a tyre, and the pressure sensor 1 measures the state of inflation thereof, whilst the accelerometer 10 performs a wake-up function, by supplying a start-of-measurement signal to the pressure sensor 1 and a data-collection signal to an electronic circuit coupled thereto. In particular, the accelerometer 10 detects a centrifugal acceleration of the tyre during rotation. An acceleration of intensity greater than a pre-set threshold is representative of a condition of movement of the vehicle, and consequently causes the start of pressure monitoring, so limiting monitoring to time intervals during which the vehicle is moving.

The dimensions of the sensors described are particularly small, namely, in the region of 0.8 mm x 0.8 mm x 0.3 mm (length x width x thickness), or in the region of 2 mm x 2 mm x 0.3 mm, so that traditional packaging techniques do not prove advantageous, and in particular packages of a traditional type, of a moulded or pre-moulded type, prove to be of excessive encumbrance and in any case not optimized for applications, such as automotive ones, which require size minimization.

On the other hand, the tendency to use alternative packaging techniques for integrated devices is known, said techniques enabling a reduction in the overall dimensions of the resulting electronic devices, and a simultaneous reduction in the manufacturing costs. In particular, the so-called "wafer-level packaging" technique is known, which envisages formation of a protection layer directly on top of a layer of semiconductor material housing integrated devices, to mechanically protect the integrated devices.

The aim of the present invention is consequently to provide a substrate-level assembly for integrated devices which will enable minimization of the costs of the manufacturing process and of the final dimensions of the corresponding electronic devices.

According to the present invention, a substrate-level assembly and a manufacturing process are consequently provided, as defined in claims 1 and 16, respectively.

For a better understanding of the present invention, preferred embodiments thereof are now described, purely by way of nonlimiting example and with reference to the attached drawings, wherein:
- Figure 1 is a cross-sectional view of a pressure sensor of a known type;
- Figure 2 is a cross-sectional view of an inertial sensor of a known type;
- Figure 3 is a cross-sectional view of a pressure monitoring system of a known type;
- Figure 4 is a cross-sectional view of a substrate-level assembly for a pressure sensor, according to an aspect of the present invention;
- Figure 5 is a cross-sectional view of a substrate-level assembly for a differential pressure sensor;
- Figure 6 is a cross-sectional view of a substrate-level assembly for a relative pressure sensor;
- Figure 7 is a cross-sectional view of a substrate-level assembly for a pressure monitoring device;
- Figure 8 is a cross-sectional view of a substrate-level assembly for an integrated device comprising a plurality of semiconductor sensors;
- Figure 9 is a cross-sectional view of an electronic device comprising a package and a substrate-level assembly, according to an aspect of the present invention; and
- Figure 10 is a perspective view of the electronic device of Figure 9.

Figure 4 shows a substrate 20 of semiconductor material, for example, monocrystalline silicon, having a front surface 20a and a rear surface 20b, opposite to the front surface 20a (in what follows, the substrate 20 will be referred to as "device substrate", in so far as it is designed to integrate one or more integrated devices, in particular, sensor devices).

An integrated device, namely a pressure sensor 1, is formed inside the device substrate 20, as described with reference to Figure 1 (so that parts that are similar are designated by the same reference numbers). In particular, the membrane 4, suspended over the buried cavity 3, is formed at the front surface 20a of the device substrate 20.

According to an aspect of the present invention, a capping substrate 21, made of semiconductor material (for example, silicon), glass, or other ceramic or polymeric material, is mechanically joined to the device substrate 20, on top of the front surface 20a, so as to coat and protect the pressure sensor 1 and so as to provide a substrate-level assembly 22 for the pressure sensor 1. In particular, by the expression "substrate-level assembly" is meant herein the composite structure comprising the device substrate 20, the capping substrate 21, and the corresponding electrical input/output connections (made as described hereinafter).

In detail, the capping substrate 21 is joined to the device substrate 20 via a bonding process, which exploits a sealing region 23, set in contact with, and on top of, the front surface 20a, to ensure joining. For example, the sealing region 23 is made of glass frit or a metal material. The sealing region 23 has a ring conformation, and surrounds, without being superimposed thereon, the membrane 4 of the pressure sensor 1. Furthermore, the sealing region 23 has a main dimension of extension of between 100 µm and 300 µm, in the case of glass-frit bonding, and smaller than 100 µm, in the case of metal bonding, with a maximum thickness of approximately 10 µm in both cases.

According to an aspect of the present invention, a sensor cavity 24 is formed within the capping substrate 21, in a position corresponding to, and in communication with, the membrane 4. The sensor cavity 24 is made, for example, via an anisotropic chemical etch, starting from a first surface 21a of the capping substrate 21 in contact with the device substrate 20, and has a depth of between 10 µm and 400 µm. Consequently, after joining between the device substrate 20 and the capping substrate 21, an empty space 25 remains over the membrane 4 so as to ensure freedom of movement thereof and so as not to alter deformation thereof as a function of a pressure applied. In particular, the empty space 25 is defined partly by the thickness of the sealing region 23 and partly by the sensor cavity 24 dug in the capping substrate 21, and is delimited partly by the sealing region 23 and partly by the walls of the sensor cavity 24.

Furthermore, a first access duct 26 is formed within the capping substrate 21, starting from a second surface 21b of the capping substrate 21, not in contact with the device substrate 20, and reaching the sensor cavity 24, in such a manner as to be fluidically connected to the empty space 25 and to the outside of the capping substrate 21.

Electrical input/output connections are finally provided for electrical connection of the pressure sensor 1 with the outside of the substrate-level assembly 22, in the form of through vias 28a, which traverse the device substrate 20 until the rear surface 20b is reached, or else in the form of connection pads 28b carried by a portion of the front surface 20a placed externally of the sealing region 23 and the capping substrate 21 so as to be accessible from the outside and enable contact using the "wire-bonding" technique (as illustrated schematically in Figure 4 and in the subsequent figures). In particular, the input/output electrical connections 28a, 28b are connected, for example, via metallizations (not shown), to the transduction elements 5 of the membrane 4. The through vias 28a can be formed with any known technique, for example, by means of conductive through holes, obtained by etching of the device substrate 20, so as to form through trenches extending throughout the thickness of the substrate, and by subsequent filling of said through trenches with a conductive material, for example, with a metal material. The use of the through vias 28a is advantageous for reducing the dimensions of the resulting assembly.

In use, a gas at a given pressure, the value of which must be determined, penetrates within the capping substrate 21 through the first access duct 26, reaches the empty space 25, and acts on the membrane 4, causing its deformation, which is detected by the transduction elements 5.

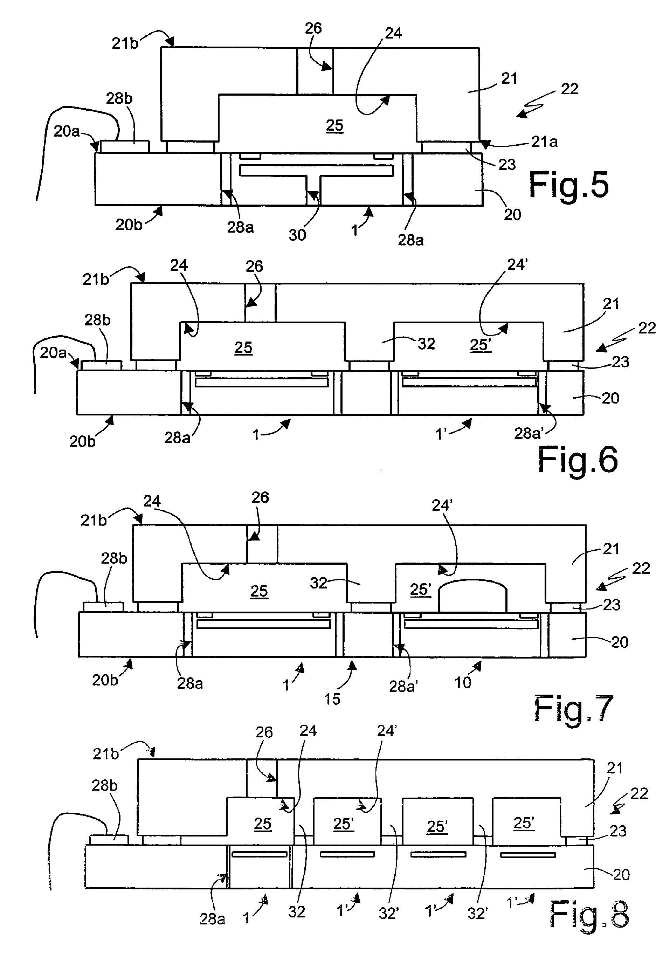

Figure 5 shows a substrate-level assembly 22 for a differential pressure sensor. In this case, a second access duct 30 is formed through the device substrate 20, starting from the rear surface 20b as far as the buried cavity 3 and so as to be in fluid connection with the buried cavity 3. For example, the second access duct 30 is made via a digging from the back of the device substrate 20 by means of an anisotropic chemical etch.

In use, the outer surface of the membrane 4 (opposite, i.e., to the buried cavity 3) is set in communication with a fluid at a first pressure through the first access duct 26 made through the capping substrate 21. The internal surface of the membrane 3, instead, is set in communication with a fluid at a second pressure through the second access duct 30. In this way, the membrane 3 deforms as a function of the difference between the first and second pressures so as to enable a differential measurement of pressure.

Figure 6 shows a substrate-level assembly 22 for a relative pressure sensor. In detail, within the device substrate 20, in addition to the pressure sensor 1, a reference pressure sensor 1' is formed, in a surface portion of the device substrate 20, separate and distinct from the one dedicated to integration of the pressure sensor 1. A further sensor cavity 24' is formed in the capping substrate 21, in a position corresponding to the reference pressure sensor 1', so as to ensure the presence of a further empty space 25' above the respective membrane 4' of the reference pressure sensor 1'. The sealing region 23 surrounds in this case the membrane of both of the pressure sensors, without being superimposed thereon, and is, for example, shaped like the figure eight. A separation portion 32 of the capping substrate 21 is placed between the sensor cavity 24, 24', and between the respective empty spaces 25, 25'. In particular, the separation portion 32, together with the underlying sealing region 23, separates in a fluid-tight manner the two empty spaces 25, 25', which are thus fluidically isolated.

In use, within the further sensor cavity 24' a gas having a given reference pressure is entrapped, whilst the sensor cavity 24 is set in fluid communication with a fluid at a given pressure through the first access duct 26 so as to implement a relative pressure measurement.

Figure 7 shows a preferred embodiment of the present invention and, in particular, a substrate-level assembly 22 for a pressure monitoring device 15 of the type described with reference to Figure 3, in particular configured to monitor the inflating pressure of a tyre of a vehicle. In detail, in distinct surface portions of the device substrate 20, a pressure sensor 1 and an accelerometer 10 are integrated. Also in this case, in a way similar to what has been described above, the further sensor cavity 24' corresponding to the accelerometer 10 is provided, so as to ensure the further empty space 25' within which the inertial mass 11 is free to move to cause a corresponding deformation of the respective membrane 4'. In addition, further input/output electrical connections 28a' are provided for ensuring electrical connection of the accelerometer 10 with the outside of the substrate-level assembly 22, also in this case in the form, for example, of through vias. Advantageously, in a way not illustrated, an appropriate electronic circuit connected to the accelerometer 10 and to the pressure sensor 1 can also be integrated within the device substrate 20.

In use, the accelerometer 10 detects an acceleration imparted on the monitoring device as a function of the deformation of the respective membrane 4', due to the displacement of the inertial mass 11. As described above, the separation portion 32 of the capping substrate 21, and the sealing region 23, set between the free spaces 25, 25' do not enable the fluid under pressure to reach the further sensor cavity 24'.

In general, the device substrate 20 can integrate an arbitrary number of sensor devices, and in this case there is provided a corresponding number of additional free spaces 25', fluidically isolated from one another, and possibly of additional sensor cavities 24', separated by additional separation portions 32' of the capping substrate 21. By way of example, in Figure 8 four sensors 1, 1' integrated in a same device substrate 20 are shown. It is clear that each one of the sensors shown can be a pressure sensor, possibly a differential pressure sensor or a relative pressure sensor, or an accelerometer, and a corresponding number of first and second access ducts can be provided.

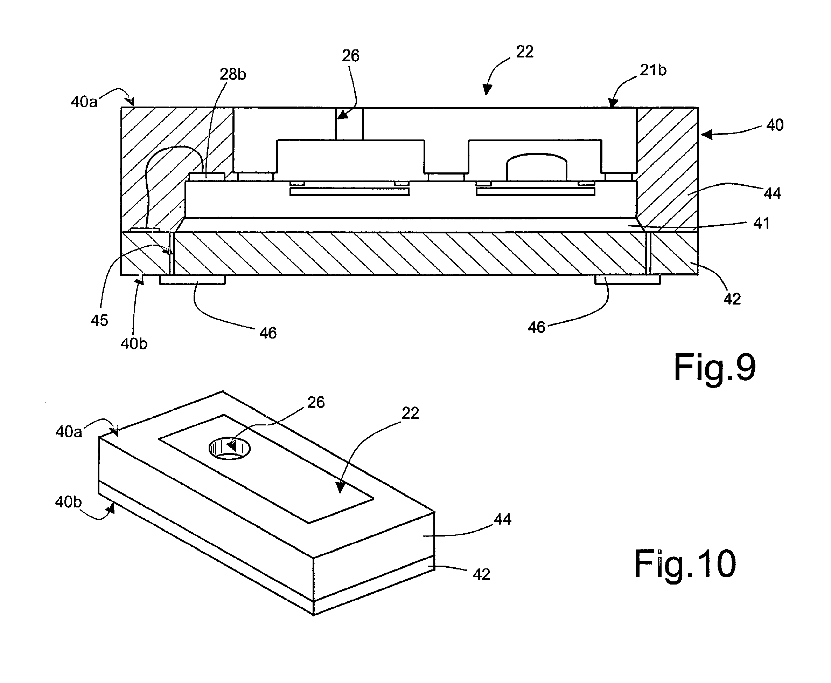

According to a further aspect of the present invention (Figures 9 and 10), the substrate-level assembly 22 can further be encased in a package 40, of a land-grid-array (LGA) type or ball-grid-array (BGA) type. In detail (Figure 9), the substrate-level assembly 22 (in particular, Figure 9 shows the case where the device substrate 20 integrates a pressure sensor 1 and an accelerometer 10) is joined, via an adhesion layer 41, to a base body 42, in particular, a multilayer organic substrate, defining the base of the package 40. The adhesion layer 41 includes an epoxy or acrylic glue, or bismaleimide (BMI), or else an epoxy, or acrylic, or bismaleimide laminated layer. The base body 42 has a size greater than that of the substrate-level assembly 22, and hence has outer portions not covered by the assembly. Then, via a mould of appropriate shape and size, the substrate-level assembly 22 is covered at the sides by a coating 44, made of plastic material, for example including resin. In particular, the coating 44 covers at the top the outer portions of the base body 42, but does not cover the second surface 21b of the capping substrate 21 (i.e., the surface not in contact with the device substrate 20), which hence constitutes part of a first outer face 40a of the package 40. In this way, the first access duct 26 remains free and exposed on the outside of the package 40 (as is evident from Figure 10). In addition, further through vias 45, formed through the base body 42, are connected to the connection pads 28b of the substrate-level assembly 22 (for example, via conductive paths, not shown, arranged at the outer portions of the base body 42), and to outer contact pads 46, made of metal material, carried by an outer surface of the base body 42, defining a second outer face 40b of the package 40. In the case of an LGA package, the contact pads 46 constitute the input/output interface towards the outside of the package 40. In the case of a BGA package, conductive bumps, for example metal balls (not shown), are instead provided for said purpose and are in direct contact with the outer contact pads 46.

The described substrate-level assembly has the following advantages.

In particular, the manufacturing process of the assembly is optimized in terms of costs and duration, in so far as it is performed directly starting from the device substrate, with process steps that are a continuation of those used for the formation of the integrated sensors. The resulting assemblies have extremely contained dimensions, which are generally in the region of 1.7 mm x 1.7 mm x 0.8 mm but can reach 1.3 mm x 1.3 mm x 0.8 mm in the case of just one pressure sensor, and which are generally in the region of 1.7 mm x 2,5 mm x 0.8 mm, but can reach 1.3 mm x 2,5 mm x 0.8 mm in the case of the pressure monitoring device (which integrates both the pressure sensor and the accelerometer). In particular, in the latter case, a single substrate-level assembly is advantageously provided for the pressure sensor and for the accelerometer, and said assembly enables an effective fluid isolation between the empty spaces provided above the membrane of the two sensors.

The substrate-level assembly can constitute a complete device made of semiconductor material, in so far as the integrated sensors housed within the device substrate are automatically protected from the back by the device substrate 20 and on the front by the capping substrate 21. However, the use of the package 40 can be advantageous in all the cases where it is not convenient to have a complete integrated device made of semiconductor material (for example, in the case where particular environmental conditions require a further protection from the outside environment). In any case, the also the package 40 has small dimensions, in the region of 3 mm x 3 mm x 1 mm.

Furthermore, the package 40, as well as the substrate-level assembly 22, can be handled and positioned easily, and in particular can be advantageously used as surface-mount devices (SMDs).

The described manufacturing process does not envisage the use of protection gels, as is, instead, required in the case of use of moulded packages of a traditional type.

Finally, it is clear that modifications and variations can be made to what is described and illustrated herein, without thereby departing from the scope of the present invention, as defined in the attached claims.

In particular, joining between the device substrate 20 and the capping substrate 21 can be made via direct or anodic bonding, so without the need to envisage the sealing region 23 on the front surface 20a of the device substrate 20. In this case, the empty space 25 above the membrane 4 is determined just by the sensor cavity 24, which accordingly must be appropriately sized.

Instead, in the case where the sealing region has a sufficient thickness, the sensor cavity 24 could not be provided within the capping substrate 21. In this case, the empty space 25 is defined and surrounded just by the sealing region 23.

Furthermore, above the membrane of the integrated sensors, a single through cavity could be provided (not illustrated), which traverses the entire thickness of the capping substrate 21 and is consequently accessible from outside the substrate-level assembly 22.

Even though Figure 9 illustrates the case where the substrate-level assembly 22 is connected to the outside via wire bonding and the connection pads 28b, it is evident that a similar structure can be provided using the through vias 28a. In particular, in this case, the through vias 28a traverse the adhesion layer 41 and are connected, for example via conductive paths, to the additional through vias 45.

In addition, further types of sensors can be integrated within the device substrate 20. In particular, a gas sensor or a microphone can be integrated therein, which also base their operation upon detection of the deformation of a membrane suspended over a cavity. Also for said sensors a respective first access duct 26 must be provided to enable, respectively, entry of a gas or of sound waves to be detected within the substrate-level assembly 22.

The deformation of the membrane 4 of the integrated sensors could be detected with capacitive, instead of piezoresistive, techniques in a known way which is not described in detail.

The inertial mass 11 could have a shape different from the one described and illustrated; in any case, it is configured so as to be affected by the accelerations imparted on the integrated device, and to undergo a consequent displacement.

Finally, it is clear that the pressure monitoring device described can be used for other applications. For example, in the automotive field, it can be used for monitoring the pressure of the air-bag, for checking the pressure of failure of an ABS system, or for monitoring the pressure of the oil or the pressure of injection of the fuel.

## Claims

1. A substrate-level assembly (22), **characterized by** comprising:
- a device substrate (20) of semiconductor material, having a top face (20a) and housing a first integrated device (1), said first integrated device (1) being provided with a buried cavity (3) formed within said device substrate (20), and a membrane (4) suspended over said buried cavity (3) in the proximity of said top face (20a);
- a capping substrate (21) mechanically coupled to said device substrate (20) above said top face (20a) so as to cover said first integrated device (1), in such a manner that a first empty space (25) is provided in a position corresponding to said membrane (4); and
- electrical-contact elements (28a, 28b) for electrical connection of said first integrated device (1) with the outside of said substrate-level assembly (22).

2. The assembly according to claim 1, wherein a first access duct (26) is provided within said capping substrate (21), said first access duct (26) being fluidically connected to said first empty space (25) and to the outside of said substrate-level assembly (22).

3. The assembly according to claim 1 or claim 2, wherein said capping substrate (21) has a first sensor cavity (24) above the membrane (4) of said first integrated device (1), said first sensor cavity (24) forming at least in part said first empty space (25); in particular, the depth of said first sensor cavity (24) being between 10 µm and 400 µm.

4. The assembly according to any one of the preceding claims, further comprising a sealing region (23) arranged between said device substrate (20) and said capping substrate (21) to ensure joining thereof, and placed in contact with said top face (20a) in such a manner as to surround, without being superimposed thereon, the membrane (4) of said first integrated device (1); said first empty space (25) being delimited, at least in part, by said sealing region (23).

5. The assembly according to claim 4, wherein said capping substrate (21) includes one between: semiconductor material, glass, ceramic, and polymeric material; and wherein said sealing region (23) includes glass frit or a metal material.

6. The assembly according to any one of the preceding claims, wherein said electrical-contact elements (28a, 28b) comprise at least one between: through vias (28a) made through said device substrate (20); and electrical-connection pads (28b) formed on a portion of said top face (20a) of said device substrate (20) not covered by said capping substrate (21) ; and wherein said integrated device further comprises transduction elements (5) configured to transform a deformation of said membrane (4) into electrical signals, and said electrical-contact elements (28a, 28b) are connected to said transduction elements (5).

7. The assembly according to any one of the preceding claims, wherein a second access duct (30) is provided within said device substrate (20), in fluid communication with said buried cavity (3) of said integrated device (1) and with the outside of said substrate-level assembly (22).

8. The assembly according to any one of the preceding claims, wherein said device substrate (20) houses at least a further integrated device (1', 10) provided with a respective buried cavity (3') formed within said device substrate (20), and with a respective membrane (4') suspended over said respective buried cavity (3'); and wherein a further empty space (25') is provided in a position corresponding to the respective membrane (4') of said further integrated device (1', 10); said further empty space (25') being fluidically isolated with respect to said first empty space (25).

9. The assembly according to claim 8, wherein said capping substrate (21) has at least one further sensor cavity (24'), set above the respective membrane (4') of said further integrated device (1', 10), and forming, at least in part, said further empty space (25'); said first empty space (25) and further empty space (25') being separated in a fluid-tight manner, at least in part, by a separation portion (32) of said capping substrate (21), placed between said first empty space (25) and further empty space (25').

10. The assembly according to claim 8 or claim 9, further comprising a sealing region (23) placed between said device substrate (20) and said capping substrate (21), and in contact with said front face (20a) of said device substrate (20), in such a manner as to surround, without being superimposed thereon, the membrane (4) of said first integrated device (1) and the respective membrane (4') of said further integrated device (1', 10); said first empty space (25) and said further empty space (25') being delimited, at least in part, by said sealing region (23).

11. The assembly according to any one of claims 8-10, wherein said first integrated device is a pressure sensor (1), and said further integrated device is an inertial sensor (10); said inertial sensor (10) comprising an inertial mass (11) arranged on the respective membrane (4'), within said further empty space (25').

12. The assembly according to claim 11, wherein said inertial mass (11) includes metal material, deposited directly on top of said respective membrane (4'); said metal material being chosen in the group comprising silver, tin, copper, lead, and gold, and having preferably a density greater than 7000 kg/m³.

13. The assembly according to any one of claims 8-10, wherein said first integrated device is a pressure sensor (1), and said further integrated device is a reference pressure sensor (1') for said pressure sensor (1).

14. An electronic device, **characterized by** comprising a substrate-level assembly (22) and a package (40) for coating and protecting mechanically said substrate-level assembly (22); wherein said substrate-level assembly (22) is made according to any one of the preceding claims, and said package (40) comprises a base body (42) mechanically coupled to said device substrate (20), and a coating region (44), configured to coat laterally said substrate-level assembly (22) and to leave uncovered and accessible from the outside a top surface (21b) of said capping substrate (21) defining part of a first outer face (40a) of said package (40), and, in particular, said first access duct (26).

15. The device according to claim 14, wherein said package (40) is of an LGA or BGA type, and has contact pads (46) carried by a surface of said base body (42), which is not in contact with said substrate-level assembly (22) and defines a second outer face (40b) of said package (40).

16. A process for manufacturing a substrate-level assembly (22), **characterized by** comprising:
- providing a device substrate (20) of semiconductor material, having a top face (20a);
- forming a first integrated device (1) within said device substrate (20), said first integrated device (1) being provided with a buried cavity (3) formed within said device substrate (20), and with a membrane (4) suspended over said buried cavity (3) in the proximity of said top face (20a);
- mechanically coupling a capping substrate (21) to said device substrate (20) above said top face (20a) so as to cover said first integrated device (1), said mechanically coupling comprising forming a first empty space (25) in a position corresponding to said membrane (4); and
- forming electrical-contact elements (28a, 28b) for electrical connection of said first integrated device (1) with the outside of said substrate-level assembly (22).

17. The process according to claim 16, further comprising forming in said capping substrate (21) a first access duct (26), fluidically connected to said first empty space (25) and to the outside of said substrate-level assembly (22).

18. Process according to claim 16 or 17, wherein forming a first empty space (25) comprises forming in said capping substrate (21) a first sensor cavity (24) above the membrane (4) of said first integrated device (1).

19. Process according to any one of claims 16-18, wherein said mechanically coupling comprises: forming a sealing region (23) set between said device substrate (20) and said capping substrate (21) and in contact with the top face (20a) of said device substrate (20) in such a manner as to surround, without being superimposed thereon, the membrane (4) of said first integrated device (1) ; and joining said device substrate (20) and said capping substrate (21) via said sealing region (23); and wherein said first empty space (25) is delimited, at least in part, by said sealing region (23).

20. The process according to any one of claims 16-19, wherein forming a first integrated device (1) further comprises forming transduction elements (5) configured to transform into electrical signals a deformation of said membrane (4), and forming electrical-contact elements (28a, 28b) comprises: forming at least one between through vias (28a) through said device substrate (20), and electrical-connection pads (28b) on a portion of said top face (20a) of said device substrate (20) not covered by said capping substrate (21); and connecting said through vias (28a), or said electrical-connection pads (28b), to said transduction elements (5).

21. The process according to any one of claims 16-20, further comprising forming in said device substrate (20) a second access duct (30) in fluid communication with said buried cavity (3) of said integrated device (1) and with the outside of said substrate-level assembly (22).

22. The process according to any one of claims 16-21, further comprising: forming in said device substrate (20) at least one further integrated device (1', 10), provided with a respective buried cavity (3') and a respective membrane (4') suspended over said respective buried cavity (3'); said mechanically coupling further comprising forming a further empty space (25') in a position corresponding to the respective membrane (4') of said further integrated device (1', 10); said further empty space (25') being fluidically isolated from said first empty space (25).

23. The process according to claim 22, wherein forming a further empty space (25') comprises forming at least a further sensor cavity (24') in said capping substrate (21), over said respective membrane (4') of said further integrated device (1', 10); said forming at least a further sensor cavity (24') comprising separating said first empty space (25) and said further empty space (25') via a separation portion (32) of said capping substrate (21).

24. The process according to claim 22 or 23, wherein said mechanically coupling comprises forming a sealing region (23) set between said device substrate (20) and said capping substrate (21) and in contact with said top face (20a) in such a manner as to surround, without being superimposed thereon, the membrane (4) of said first integrated device (1) and the respective membrane (4') of said further integrated device (1', 10); said first empty space (25) and said further empty space (25') being delimited, at least in part, by said sealing region (23).

25. The process according to any one of claims 22-24, wherein forming a first integrated device comprises forming a pressure sensor (1), and forming at least one further integrated device comprises forming an inertial sensor (10); forming an inertial sensor (10) comprising forming an inertial mass (11) on said respective membrane (4') and within said further empty space (25').

26. The process according to claim 25, wherein forming an inertial mass (11) comprises depositing directly on top of said respective membrane (4') metal material chosen in the group comprising silver, tin, copper, lead, and gold, and having preferably a density higher than 7000 kg/m³.

27. The process according to any one of claims 22-24, wherein forming a first integrated device comprises forming a pressure sensor (1), and forming at least one further integrated device comprises forming a reference pressure sensor (1') for said pressure sensor (1).

28. A process for manufacturing an electronic device, **characterized by** comprising: forming a substrate-level assembly (22); and encasing said substrate-level assembly (22) in a package (40), for coating and mechanically protecting said substrate-level assembly (22); wherein said substrate-level assembly (22) is made with a process according to any one of claims 16-27, and said encasing comprises mechanically coupling a base body (42) to said device substrate (20), and coating laterally said substrate-level assembly (22) with a coating region (44), said coating region (44) being configured to coat laterally said substrate-level assembly (22) and to leave uncovered and accessible from the outside a top surface (21b) of said capping substrate (21) defining part of a first outer face (40a) of said package (40), and, in particular, said first access duct (26).

29. The process according to claim 28, comprising forming contact pads (46) at a surface of said base body (42), which is not in contact with said substrate-level assembly (22) and defines a second outer face (40b) of said package (40).
